# EUROPEAN PATENT SPECIFICATION

(11) **EP 2 717 355 B1**
(45) Date of publication and mention of the grant of the patent: **22.06.2016**
(21) Application number: 12788771.9
(22) Date of filing: 16.03.2012
(51) Int. Cl.: H01M 4/38, C22C 30/04, C22C 30/00, H01M 10/0525, C23C 14/18, C23C 14/34

(54) **NEGATIVE ELECTRODE ACTIVE MATERIAL FOR ELECTRICAL DEVICES**
NEGATIVELEKTRODEN-AKTIVMATERIAL FÜR ELEKTRISCHE VORRICHTUNGEN
MATÉRIAU ACTIF D'ÉLECTRODE NÉGATIVE POUR DISPOSITIFS ÉLECTRIQUES

(30) Priority: 25.05.2011 JP 2011116707
(43) Date of publication of application: 09.04.2014
(73) Proprietor: Nissan Motor Co., Ltd, Yokohama-shi, Kanagawa 221-0023 (JP)
(72) Inventor: WATANABE, Manabu, Kanagawa 243-0123 (JP); YOSHIDA, Masao, Kanagawa 243-0123 (JP); TANAKA, Osamu, Kanagawa 243-0123 (JP)
(74) Representative: Hoefer & Partner Patentanwälte mbB
(86) International application number: PCT/JP2012/056928
(87) International publication number: WO 2012/160866

(56) References cited:
- WO-A1-2004/086539
- WO-A1-2011/142216
- JP-A- 2004 185 810
- JP-A- 2004 296 412
- JP-A- 2005 011 650
- JP-A- 2006 216 277
- JP-A- 2007 149 604
- JP-A- 2009 032 644
- JP-A- 2009 517 850

## Description

### TECHNICAL FIELD

The present invention relates to a negative electrode active material for an electric device, for example, represented by a secondary battery used suitably for power supply for motor drive of an electric vehicle (EV) or a hybrid electric vehicle (HEV), a capacitor or the like. Further, it relates to a negative electrode, an electric device and a lithium-ion secondary battery using the same.

### BACKGROUND ART

In recent years, as a measure against air pollution and global warming, various efforts have been made to decrease CO₂ emissions. In particular, in the automotive industry, the decrease in CO₂ emissions by the introduction of electric vehicles and hybrid electric vehicles is expected. Further, as a power supply for motor drive of these vehicles, developments of high-performance secondary batteries are progressing. As the above-mentioned secondary battery for motor drive, it is required, in particular, to have a high capacity and excellent cycling properties. Therefore, among various secondary batteries, a lithium-ion secondary battery having high theoretical energy attracts attention.

In order to raise the energy density in such a lithium-ion secondary battery, it is necessary to raise quantity of electricity stored per unit mass of a positive electrode and a negative electrode. Further, in order to satisfy the requirement, the selection of active materials for each of these is extremely important.

As a method for manufacturing an electrode material for a lithium-ion secondary battery that has a large discharge capacity per volume and, in addition, is excellent in charge and discharge cycling characteristics, for example, in Patent Literature 1, the following manufacturing method is proposed. That is, Si fine particles having a prescribed average particle diameter and specific surface area, which is obtained by pulverizing powder containing Si as a main component with a wet type media mill, is prepared. Then, to the particles, metal powder containing prescribed elements such as Sn and Al, and carbon powder are added, which is dry-pulverized with a ball mill. The method for manufacturing an electrode material by obtaining complex particles having a prescribed average particle diameter and specific surface area in this way is proposed. Furthermore, there is described the use of the electrode obtained in this way as a negative electrode of a lithium-ion secondary battery.

### CITATION LIST

### PATENT LITERATURE

Patent Literature 1: Japanese Patent Application Laid-Open Publication No. 2006-216277

### SUMMARY OF INVENTION

However, in the lithium-ion secondary battery using the negative electrode material described in Patent Literature 1, when Si and Li are alloyed, transition from an amorphous state to a crystalline state is generated. As the result, a large volume change occurs, and there is such a problem that a cycle life of the electrode decreases. Further, in the case of such a Si-based active material, capacity and cycle durability are in the relation of tradeoff, and it is a task to maintain a high capacity and improve the durability.

Consequently, the present invention has an object to provide a negative electrode active material for an electric device such as a lithium-ion secondary battery that can suppress a phase transition of amorphous-crystal to improve the cycle life and has a high capacity. Further, the present invention has an object to provide a negative electrode to which the negative electrode active material is applied, and an electric device using the same, for example, a lithium-ion secondary battery.

The negative electrode active material for an electric device according to an aspect of the present invention includes an alloy containing Si in a range from 12% by mass or more to less than 100% by mass, Sn in a range from more than 16% by mass to 45% by mass or less, Al in a range from more than 18% by mass to 43% by mass or less, and indispensable impurities as remains. Further, the negative electrode for an electric device of the present invention includes the negative electrode active material of the present invention. Furthermore, an electric device of the present invention includes the negative electrode active material of the present invention or the negative electrode of the present invention. Meanwhile, as a representative of the electric device of the present invention, a lithium-ion secondary battery can be mentioned.

### BRIEF DESCRIPTION OF DRAWINGS

[FIG. 1] FIG. 1 is a ternary composition diagram that shows the composition range of an Si-Sn-Al-based alloy constituting the negative electrode active material for an electric device of the present invention and plots alloy components deposited in Examples.
[FIG. 2] FIG. 2 is a ternary composition diagram that shows a suitable composition range of the Si-Sn-Al-based alloy constituting the negative electrode active material for an electric device of the present invention.
[FIG. 3] FIG. 3 is a ternary composition diagram that shows a more suitable composition range of the Si-Sn-Al-based alloy constituting the negative electrode active material for an electric device of the present invention.
[FIG. 4] FIG. 4 is a ternary composition diagram that shows a furthermore suitable composition range of the Si-Sn-Al-based alloy constituting the negative electrode active material for an electric device of the present invention.
[FIG. 5] FIG. 5 is a schematic cross-sectional view that shows an example of a lithium-ion secondary battery according to an embodiment of the present invention.

### DESCRIPTION OF EMBODIMENTS

Hereinafter, the negative electrode active material for an electric device of the present invention will be described in detail, while employing a negative electrode for a lithium-ion secondary battery and a lithium-ion secondary battery using the negative electrode active material as examples. Meanwhile, in the present description, "%" shall represent mass percentage, unless otherwise defined in particular. Further, dimensional ratios in the drawings are exaggerated for convenience of explanation, and they may be different from actual ratios.

### [Negative electrode active material for electric device]

The negative electrode active material for a lithium-ion secondary battery according to an embodiment of the present invention will be described in detail.

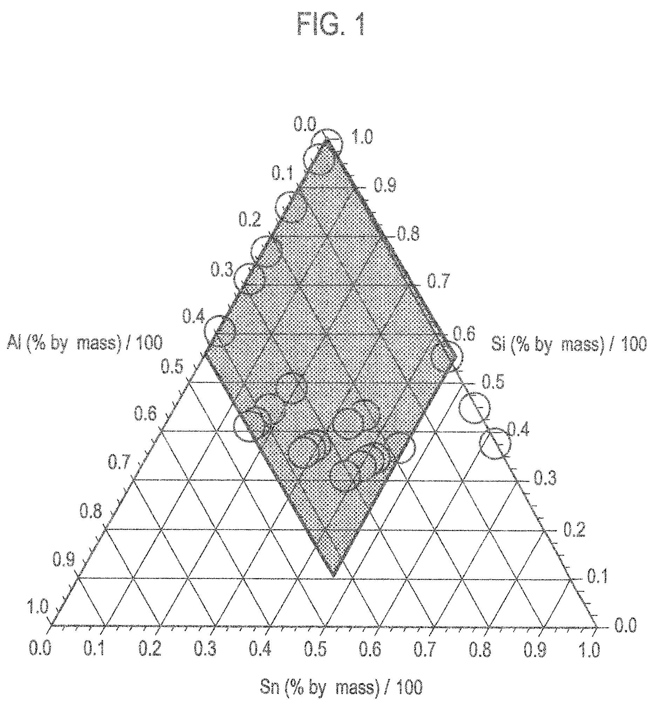

The negative electrode active material for an electric device of the present invention has, as described above, an alloy containing Si in a range from 12% by mass or more to less than 100% by mass, Sn in a range from more than 16% by mass to 45% by mass or less, Al in a range from more than 18% by mass to 43% by mass or less, and indispensable impurities as remains. Meanwhile, the composition of the alloy is shown by a shaded part in FIG. 1.

The negative electrode active material is used for an electric device, for example, for a negative electrode of a lithium-ion secondary battery. In this case, the alloy contained in the above-mentioned negative electrode active material absorbs lithium ions upon charge of the battery and releases lithium ions upon discharge. Further, the above-mentioned negative electrode active material contains, in a suitable amount, a first additive element Sn and a second additive element Al that suppress the phase transition of amorphous-crystal when being alloyed with lithium by charge and improve the cycle life. By the selection of such additive elements, the negative electrode active material expresses a higher capacity than a conventional negative electrode active material, specifically a carbon-based negative electrode active material. Further, by optimizing the composition range of Sn and Al that are the first and second additive elements, the Si-Sn-Al-based alloy negative electrode active material of the present invention not only expresses a high capacity but also maintains a high discharge capacity after 50 cycles and 100 cycles. That is, it is an Si-Sn-Al-based alloy negative electrode active material having a good cycle life.

Here, in the negative electrode active material of the present invention including the Si-Sn-Al-based alloy, when the Sn content is more than 45%, or the Al content is more than 43%, the initial capacity tends to lower. On the other hand, when Sn or Al is not contained, it tends not to show a good cycle life.

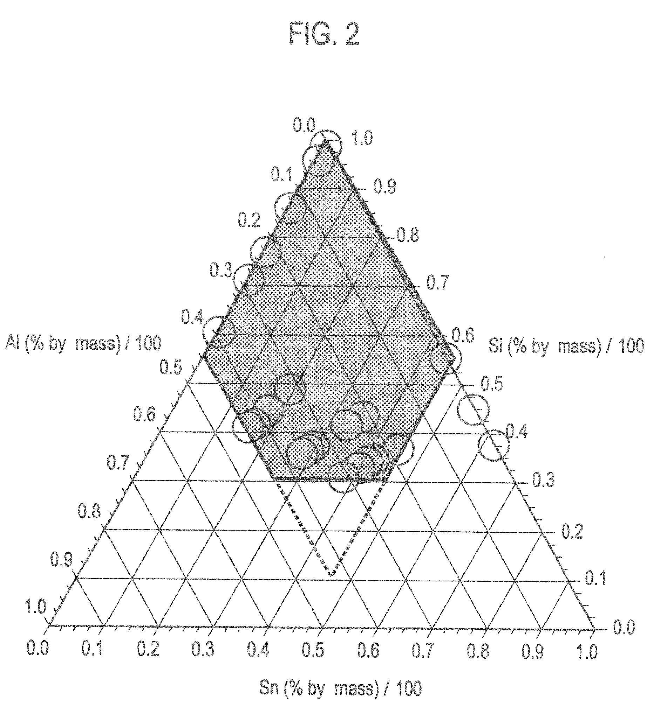

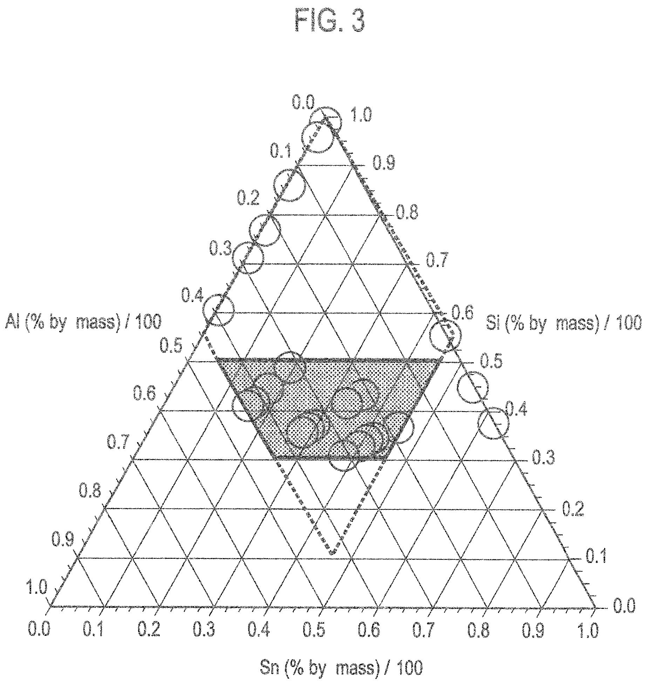

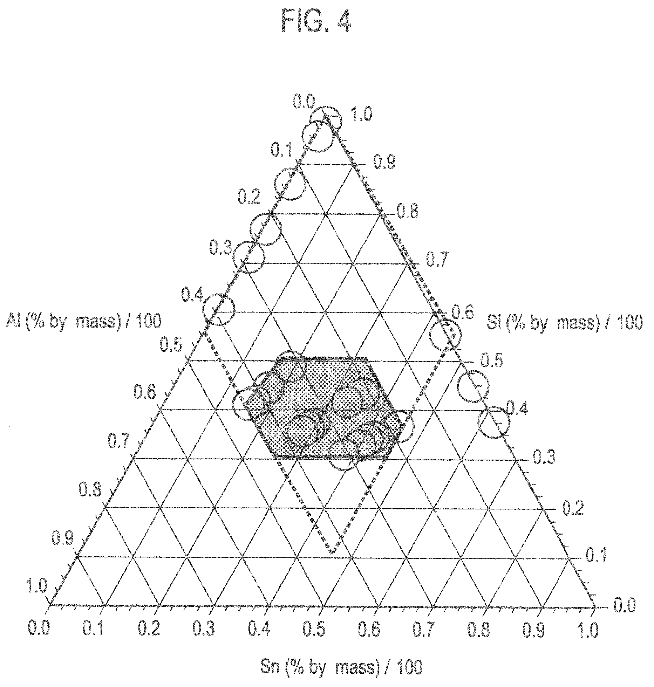

Meanwhile, from the viewpoint of improving the above-mentioned characteristics of the negative electrode active material, as shown by the shaded part in FIG. 2, the Si content is preferably in the range of 31% or more. Further, more preferably, as shown by the shaded part in FIG. 3, the Si content is set in the range from 31 to 50%. Furthermore, as shown by the shaded part in FIG. 4, the Sn content is set in the range from 16 to 45%, and the Al content
is set in the range from 18 to 43%.

Meanwhile, in addition to the above-mentioned three components, the negative electrode active material of the present invention cannot avoid the inclusion of impurities derived from raw materials or manufacturing method. The content of such indispensable impurities is preferably less than 0.5% by mass, more preferably less than 0.1% by mass.

Here, the alloy contained in the negative electrode active material of the present embodiment is an alloy, as described above, that contains Si in the range from 12% by mass or more to less than 100% by mass, Sn in the range from more than 16% by mass to 45% by mass or less, Al in the range
from more than 18% by mass to 43% by mass or less, and
indispensable impurities as remains. Consequently, in other words, the above-mentioned alloy includes only of Si in the range from 12% by mass or more to less than 100% by mass, Sn in the range more than 16% by mass to 45% by mass or less,
Al in the range from more than 18% by mass to 43% by mass or
less, and indispensable impurities.

The manufacturing method of the negative electrode active material of the present invention, that is, the Si-Sn-Al-based alloy having the above-mentioned composition is not particularly restricted, and the material can be manufactured utilizing conventionally known various manufacturings. That is, since there is hardly any difference in alloy states and characteristics caused by production methods, any of conventionally known production methods can be applied without trouble.

Specifically, for example, by utilizing a multiple PVD method (a sputtering method, a resistance heating method, a laser ablation method), a multiple CVD method (chemical vapor deposition method) or the like, an alloy having the above-mentioned composition in a thin film form can be obtained. As the multiple PVD method, a sputtering method, a resistance heating method, or a laser ablation method can be employed. As the multiple CVD method, a chemical vapor deposition method can be employed. By direct formation (deposition) on a current collector, such alloy thin film can be made into a negative electrode. Consequently, it is excellent in terms of achieving simplification/shortening of processes. Furthermore, the use of other components for constituting the negative electrode active material layer other than the alloy, such as a binder and a conductive assistant, is unnecessary, and the alloy thin film as the negative electrode active material can directly be set to be a negative electrode. Consequently, it is excellent in terms of achieving a high capacity and high energy density that satisfy a practical level of vehicle application. Further, it is also suitable for examining electrochemical characteristics of the active material.

When manufacturing the above-mentioned alloy thin film, a multiple DC magnetron sputtering apparatus can be used, and, for example, an independently controlled ternary DC magnetron sputtering apparatus is employed. This makes it possible to form freely an Si-Sn-Al-based alloy thin film having various alloy compositions and thicknesses on the surface of a substrate (current collector) . For example, in a ternary DC magnetron sputtering apparatus, a target 1 (Si), a target 2 (Sn) and a target 3 (Al) are used. Then, sputtering time is fixed, and, for example, power of DC power sources is varied respectively, such as Si: 185 W, Sn: 0 to 40 W, and Al: 0 to 150 W. Consequently, alloy samples of a ternary system having various composition formulae can be obtained. Since sputtering conditions are different for every sputtering apparatus, however, for every sputtering apparatus, it is desirable to grasp appropriately a suitable range through a preliminary experiment etc.

Here, as mentioned above, the negative electrode active material layer of the present embodiment can use a thin film of the above-mentioned Si-Sn-Al-based alloy. However, the negative electrode active material layer may be a layer containing particles of the above-mentioned Si-Sn-Al-based alloy as a main component. As a method for manufacturing the alloy in a particulate form that has the above-mentioned composition, for example, a mechanical alloy method, an arc plasma melting method or the like can be utilized. When using the alloy in a particulate form as the negative electrode active material, first, slurry is prepared by adding a binder, a conductive assistant, a viscosity-adjusting solvent and the like to the alloy particles. After that, by forming a negative electrode active material layer on a current collector using the slurry, it is possible to obtain a negative electrode. Accordingly, the negative electrode active material is excellent in that a mass production is easy and a practical application as an actual electrode for a battery is easy.

Meanwhile, when the alloy in a particulate form is used as the negative electrode active material, the average particle diameter thereof is not particularly restricted, only if it is at the same level as that of a conventional negative electrode active material. However, from the viewpoint of increasing the output power, it is preferably in the range of 1 to 20 µm. Needless to say, if the above-mentioned operation effect can be expressed effectively, the diameter is not restricted to the range in any way, but may be outside the above-mentioned range.

Meanwhile, in the present description, "the particle diameter" means the largest distance among distances between arbitrary two points on a profile line of an active material particle (observed face) observed using such an observation unit as a scanning electron microscope (SEM) or a transmission electron microscope (TEM). As the value of "the average particle diameter, " a value, which is calculated as an average value of particle diameters observed in several to dozens of fields of view using such an observation unit as a scanning electron microscope (SEM) or a transmission electron microscope (TEM), shall be employed. A particle diameter and an average particle diameter of other constituent components can be defined in the same way.

### [Negative electrode for electric device, and electric device]

The negative electrode for an electric device of the present invention is one that uses the negative electrode active material including the above-mentioned Si-Sn-Al-based alloy. Then, a lithium-ion secondary battery that is typical as an electric device has at least one single cell that is equipped with a negative electrode including a negative electrode active material layer that contains the negative electrode active material on the surface of a current collector, along with an electrolyte layer and a positive electrode. Hereinafter, the constitution of the lithium-ion secondary battery and materials thereof will be described respectively.

### (Constitution of lithium-ion secondary battery)

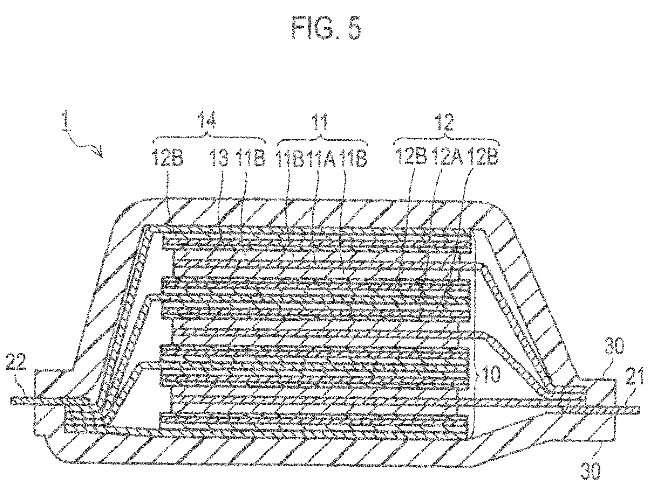

In FIG. 5, a lithium-ion secondary battery according to an embodiment of the present invention is exemplified. As shown in FIG. 5, the lithium-ion secondary battery 1 of the present embodiment has a constitution that a battery element 10, to which a positive electrode tab 21 and a negative electrode tab 22 are attached, is sealed inside a sheathing body 30. Further, in the present embodiment, the positive electrode tab 21 and the negative electrode tab 22 are led out in opposite directions respectively from the inside of the sheathing body 30 toward the outside. Meanwhile, although not shown in the drawing, an constitution, in which the positive electrode tab and the negative electrode tab are led out in the same direction from the inside of the sheathing body toward the outside, may be employed. The positive electrode tab and the negative electrode tab can be attached to a positive electrode current collector and a negative electrode current collector to be described later, for example, by ultrasonic welding, resistance welding, or the like.

### (Positive electrode tab and negative electrode tab)

The above-mentioned positive electrode tab 21 and the negative electrode tab 22 are constituted, for example, by such a material as aluminum (Al), copper (Cu), titanium (Ti), nickel (Ni), stainless steel (SUS), or an alloy of these. However, the material is not restricted to these, but conventionally known materials that can be used as a tab for a lithium-ion secondary battery can be used. Meanwhile, for the positive electrode tab and the negative electrode tab, the same material may be used, or different materials may be used. Further, as the present embodiment, tabs separately prepared may be connected to a positive electrode current collector and a negative electrode current collector to be described later, or, when each of positive electrode current collectors and each of negative electrode current collectors to be described later are in a foil shape, tabs may be formed by elongating respective foils.

### (Sheathing body)

The above-mentioned sheathing body 30 is, for example, preferably one formed from a film-shaped sheathing material, from the viewpoint of size reduction and weight reduction. However, the sheathing body is not restricted to this, but one formed from a conventionally known material for a sheathing body for a lithium-ion secondary battery can be used. Meanwhile, when the application object is an automobile, in order to conduct heat effectively from a heat source of the automobile and to heat quickly the inside of the battery to a battery operation temperature, for example, the use of a polymer-metal composite laminate sheet excellent in thermal conductivity is suitable.

### (Battery element)

As shown in FIG. 5, the battery element 10 in the lithium-ion secondary battery 1 of the present embodiment has a constitution in which a plurality of single cell layers 14 each of which includes a positive electrode 11, an electrolyte layer 13 and a negative electrode 12 is laminated. The positive electrode 11 has a constitution in which a positive electrode active material layer 11B is formed on both main surfaces of a positive electrode current collector 11A. Further, the negative electrode 12 has a constitution in which a negative electrode active material layer 12B is formed on both main surfaces of a negative electrode current collector 12A.

On this occasion, the positive electrode active material layer 11B formed on one of the main surfaces of the positive electrode current collector 11A in one positive electrode 11 and the negative electrode active material layer 12B formed on one of the main surfaces of the negative electrode current collector 12A in a negative electrode 12 adjacent to the positive electrode 11 face each other via the electrolyte layer 13. In this way, the positive electrode, the electrolyte layer and the negative electrode are laminated in this order in plural numbers, and the adjacent positive electrode active material layer 11B, electrolyte layer 13 and negative electrode active material layer 12B constitute one single cell layer 14. That is, the lithium-ion secondary battery 1 of the present embodiment is to have a constitution of being connected in parallel electrically, by the lamination of plural single cell layers 14. Meanwhile, for the negative electrode current collector 12A lying on the outermost layer of the battery element 10, the negative electrode active material layer 12B is formed only on one surface.

Moreover, for the outer periphery of the single cell layer 14, in order to insulate between the positive electrode current collector 11A and the negative electrode current collector 12A that are adjacent to each other, an insulating layer, which is not shown in the drawing, may be provided. The insulating layer is preferably formed on the outer periphery of the single cell layer from a material capable of holding electrolytes contained in the electrolyte layer or the like and of preventing leak of the electrolytes. Specifically, general-purpose plastics such as polypropylene (PP), polyethylene (PE), polyurethane (PUR), polyamide-based resin (PA), polytetrafluoroethylene (PTFE), polyvinylidene fluoride (PVdF) or polystyrene (PS) can be used. Further, thermoplastic olefin rubber, silicone rubber, or the like can also be used.

### (Positive electrode current collector and negative electrode current collector)

The positive electrode current collector 11A and the negative electrode current collector 12A are constituted, for example, of a foil-shaped or mesh-shaped electroconductive material such as aluminum, copper or stainless steel (SUS). However, they are not restricted to these, but conventionally known materials that may be used as a current collector for a lithium-ion secondary battery can be used. The size of the current collector can be determined in accordance with the use application of the battery. For example, when it is used for a battery with a large size for which a high energy density is required, a current collector of a large area is used. The thickness of the current collector is also not particularly restricted. The thickness of the current collector is, usually, around 1 to 100 µm. The shape of the current collector is also not particularly restricted. In the battery element 10 shown in FIG. 5, other than a current collector foil, a meshed shape (such as an expanded grid) or the like can be used. Meanwhile, when forming directly a thin film alloy being the negative electrode active material on the negative electrode current collector 12A by a sputtering method or the like, the use of a current collector foil is desirable.

No particular restriction is imposed on a material for constituting the current collector. For example, a metal or a resin in which an electroconductive filler is added to an electroconductive polymer material or an non-electroconductive polymer material can be employed. Specifically, as the metal, aluminum, nickel, iron, stainless steel, titanium, copper or the like is mentioned. Other than these, the use of a cladding material of nickel and aluminum, a cladding material of copper and aluminum, or a plated material of the combination of these metals is preferable. Further, a foil in which aluminum is covered on the metal surface is also usable. Among these, from the viewpoint of electron conductivity, battery operating potential, adhesiveness of the negative electrode active material to the current collector by sputtering and the like, aluminum, stainless steel, copper or nickel is preferable.

Examples of the electroconductive polymer material include polyaniline, polypyrrole, polythiophene, polyacetylene, polyparaphenylene, polyphenylenevinylene, polyacrylonitrile, polyoxadiazole and the like. These electroconductive polymer materials have sufficient electroconductivity even if an electroconductive filler is not added, and, therefore, they are advantageous in terms of facilitating manufacturing process or of reducing weight of the current collector.

Examples of the non-electroconductive polymer material include polyethylene (PE; high density polyethylene (HDPE), low density polyethylene (LDPE) etc.), polypropylene (PP), polyethylene terephthalate (PET), polyethernitrile (PEN), polyimide (PI), polyamideimide (PAI), polyamide (PA), polytetrafluoroethylene (PTFE), styrene-butadiene rubber (SBR), polyacrylonitrile (PAN), polymethyl acrylate (PMA), polymethyl methacrylate (PMMA), polyvinyl chloride (PVC), polyvinylidene fluoride (PVdF), polystyrene (PS) and the like. Such non-electroconductive polymer materials have excellent dielectric voltage characteristics or solvent resistance characteristics.

To the above-mentioned electroconductive polymer materials or to the non-electroconductive polymer materials, if necessary, an electroconductive filler can be added. In particular, when a resin to be a base material of the current collector includes only a non-electroconductive polymer, an electroconductive filler is indispensable in order to give electroconductivity to the resin. As the electroconductive filler, any material can be used if it has electroconductivity, without particular restriction. For example, as a material excellent in electroconductivity, dielectric voltage characteristics or lithium ion shielding characteristics, a metal, an electroconductive carbon or the like are mentioned. As the metal, although there is no particular restriction, it is preferable to contain at least one metal selected from the group including Ni, Ti, Al, Cu, Pt, Fe, Cr, Sn, Zn, In, Sb and K, or an alloy or metal oxide containing these metals. Further, as the electroconductive carbon, although there is no particular restriction, it is preferably one containing at least one kind selected from the group including acetylene black, VULCAN (registered trade mark), BLACK PEARL (registered trade mark), carbon nanofiber, Ketjenblack (registered trade mark), carbon nanotube, carbon nanohorn, carbon nanobaloon and fullerene. The addition amount of the electroconductive filler is not particularly restricted, if it can give sufficient electroconductivity to the current collector, and, generally, is around 5 to 35% by mass of the whole current collector.

However, it is not restricted to these, but conventionally known materials used as the current collector for a lithium-ion secondary battery can be used.

### (Positive electrode)

In lithium-ion secondary batteries, the positive electrode 11 is constituted by forming the positive electrode active material layer 11B on one surface or both surfaces of the positive electrode current collector 11A including an electroconductive material such as an aluminum foil, a copper foil, a nickel foil, or a stainless steel foil. Meanwhile, the thickness of the positive electrode current collector is not particularly restricted, as aforementioned, and is preferably around 1 to 30 µm in general.

The positive electrode active material layer 11B contains, as a positive electrode active material, any of one kind or two or more kinds of positive electrode materials capable of occluding and discharging lithium, and may contain, if necessary, a conductive assistant and a binder. Meanwhile, the compounding ratio of these positive electrode active material, conductive assistant and binder in the positive electrode active material layer is not particularly restricted.

Examples of the positive electrode active material include lithium-transition metal complex oxides, lithium-transition metal phosphate compounds, lithium-transition metal sulfate compounds, solid solution systems, ternary systems, NiMn systems, NiCo systems, spinel Mn systems and the like.

Examples of the lithium-transition metal complex oxides include LiMn₂O₄, LiCoO₂, LiNiO₂, Li (Ni, Mn, Co) O₂, Li (Li, Ni, Mn, Co) O₂, LiFePO₄ and the like. Further, those in which a part of the transition metal of these complex oxides is substituted by another element can also be employed. Examples of the solid solution systems include xLiMO₂. (1-x) Li₂NO₃ (0 < x < 1, M is one or more transition metals having an average oxidation state of 3+, N is one or more transition metals having an average oxidation state of 4+), LiRO₂-LiMn₂O₄ (R is an transition metal element such as Ni, Mn, Co, Fe or the like), and the like.

Examples of the ternary systems include a nickel/cobalt/manganese-based complex positive electrode material and the like. Examples of the spinel Mn systems include LiMn₂O₄ and the like. Examples of the NiMn systems include LiNi_{0.5}Mn_{1.5}O₄ and the like. Examples of the NiCo systems include Li(NiCo)O₂ and the like. Depending on conditions, two or more positive electrode active materials may be used together. From the viewpoint of capacity and output characteristics, the lithium-transition metal complex oxide is used suitably as the positive electrode active material.

Meanwhile, the particle diameter of the above-mentioned positive electrode active material is not particularly restricted, but, generally, finer particles are more desirable. Further, in consideration of a working efficiency and easiness of handling, around 1 to 30 µm is suitable in an average particle diameter, and around 5 to 20 µm is more preferable. Further, needless to say, positive electrode active materials other than those described above are also employable. When each of active materials has the optimum particle diameter different from each other for expressing respective specific effects, it is sufficient to blend and use the most suitable particle diameters for expressing respective specific effects each other. That is, it is not always necessary to equalize particle diameters of all the active materials.

The binder is added for the purpose of binding active materials or the active material and the current collector, to keep an electrode structure. As the binder, a thermoplastic resin such as polyvinylidene fluoride (PVDF), polytetrafluoroethylene (PTFE), polyvinyl acetate, polyimide (PI), polyamide (PA), polyvinyl chloride (PVC), polymethyl acrylate (PMA), polymethyl methacrylate (PMMA), polyethernitrile (PEN), polyethylene (PE), polypropylene (PP) or polyacrylonitrile (PAN), a thermosetting resin such as epoxy resin, polyurethane resin or urea resin, or a rubber-based material such as styrene-butadiene rubber (SBR) can be used.

The conductive assistant is also referred simply as a conductive agent, which means an electroconductive additive to be compounded for improving electroconductivity. The conductive assistant for use in the present invention is not particularly restricted, and conventionally known one can be utilized. Examples of the conductive assistant include carbon materials such as carbon black including acetylene black, graphite and carbon fiber. By incorporating the conductive assistant, an electron network inside the active material layer is formed effectively, which contributes to improving output characteristics of a battery and improving reliability caused by improvement of retainability of an electrolytic liquid.

### (Negative electrode)

On the other hand, the negative electrode 12 is constituted, in the same way as the positive electrode, by forming the negative electrode active material layer 12B on one surface or both surfaces of the negative electrode current collector 12A including the electroconductive material as described above.

The negative electrode active material layer 12B contains, as a negative electrode active material, any of one kind or two or more kinds of negative electrode materials capable of occluding and discharging lithium, and may contain, if necessary, a conductive assistant and a binder similar to those in the case of the positive electrode active material. Meanwhile, the compounding ratio of these negative electrode active material, conductive assistant and binder in the negative electrode active material layer is not particularly restricted.

The lithium-ion secondary battery that is an electric device of the present invention includes the negative electrode active material containing the Si-Sn-Al-based alloy having the composition described above as an indispensable component. Further, as described above, the negative electrode active material layer 12B according to the present embodiment may be a thin film made of the Si-Sn-Al-based alloy. In this case, the negative electrode active material layer 12B may be formed only from the Si-Sn-Al-based alloy, and combined use of a conventionally known negative electrode active material capable of reversibly occluding and discharging lithium, which is to be described later, generates no trouble.

Moreover, as mentioned above, the negative electrode active material layer 12B may be a layer containing particles of the Si-Sn-Al-based alloy as the main component. In this case, according to need, to the negative electrode active material layer 12B, the above-mentioned conductive assistant and binder that can be incorporated to the positive electrode active material layer 11B may be incorporated. Meanwhile, in the present description, "the main component" means a component of which the content in the negative electrode active material layer 12B is 50% by mass or more.

Examples of the above-mentioned negative electrode active material used together include carbon materials such as graphite (natural graphite, artificial graphite, etc.) that is high crystallinity carbon, low crystallinity carbon (soft carbon, hard carbon), carbon black (Ketjenblack, acetylene black, channel black, lampblack, oil-furnace black, thermal black, etc.), fullerene, carbon nanotube, carbon nanofiber, carbon nanohorn, and carbon fibril. Further, as the negative electrode active material, a single body of an element that is to be alloyed with lithium such as Si, Ge, Sn, Pb, Al, In, Zn, H, Ca, Sr, Ba, Ru, Rh, Ir, Pd, Pt, Ag, Au, Cd, Hg, Ga, Tl, C, N, Sb, Bi, O, S, Se, Te or Cl, oxide or carbide containing these elements, or the like can be mentioned. As the oxide, silicon monoxide (SiO), SiOₓ (0 < x < 2), tin dioxide (SnO₂), SnOₓ (0 < x < 2), SnSiO₃ or the like can be mentioned, and, as the carbide, silicon carbide (SiC) or the like can be mentioned. Furthermore, as the negative electrode active material, metal material such as lithium metal or lithium-transition metal complex oxide such as lithium-titanium complex oxide (lithium titanate: Li₄Ti₅O₁₂) can be mentioned. Meanwhile, these negative electrode active materials may be used singly, or may be used in a form of a mixture of two or more kinds.

As described above, the negative electrode may be one in which a negative electrode active material layer is formed by applying slurry containing a conductive assistant and binder with the negative electrode active material on the surface of the negative electrode current collector. Further, as the negative electrode, one, in which a thin film of the negative electrode active material alloy is deposited directly on the surface of the negative electrode current collector by a multiple PVD method, a CVD method or the like, may also be used.

Meanwhile, as explained in the above that the positive electrode active material layer and the negative electrode active material layer are formed on one surface or both surfaces of each of the current collectors, it is also possible to form the positive electrode active material layer on one surface of one current collector and to form the negative electrode active material layer on the other surface. The electrode can be applied to a bipolar battery.

### (Electrolyte layer)

The electrolyte layer 13 is a layer containing a nonaqueous electrolyte, and the nonaqueous electrolyte has a function as a carrier of lithium ions moving between positive and negative electrodes upon charging and discharging. Meanwhile, the thickness of the electrolyte layer 13 is preferably made as small as possible from the viewpoint of reducing an internal resistance, and is usually around 1 to 100 µm, preferably in the range of 5 to 50 µm.

As the nonaqueous electrolyte contained in the electrolyte layer 13, it is not particularly restricted when it can exert a function as a carrier for lithium ions, and a liquid electrolyte or a polymer electrolyte can be used.

The above-mentioned liquid electrolyte has such a constitution that a lithium salt (electrolyte salt) is dissolved in an organic solvent. Examples of the organic solvent include carbonates such as ethylene carbonate (EC), propylene carbonate (PC), butylene carbonate (BC), vinylene carbonate (VC), dimethyl carbonate (DMC), diethyl carbonate (DEC), ethyl methyl carbonate (EMC) and methyl propyl carbonate (MPC). As the lithium salt, a compound that may be added to the electrode active material layer such as Li(CF₃SO₂)₂N, Li(C₂F₅SO₂)₂N, LiPF₆, LiBF₄, LiAsF₆, LiTaF₆, LiClO₄ or LiCF₃SO₃ can be used.

The above-mentioned polymer electrolyte is classified into a gel polymer electrolyte (gel electrolyte) containing an electrolytic liquid, and a genuine polymer electrolyte not containing an electrolytic liquid. The gel polymer electrolyte has such a constitution that is formed by pouring the above-mentioned liquid electrolyte in matrix polymer (host polymer) preferably made of an ion-conducting polymer. The use of the gel polymer electrolyte as an electrolyte is excellent in that fluidity of the electrolyte does not exist and shielding of ion conduction between respective layers is easy.

The ion-conducting polymer for use as the matrix polymer (host polymer) is not particularly restricted, and examples thereof include polyethylene oxide (PEO), polypropylene oxide (PPO), polyvinylidene fluoride (PVDF), copolymer of polyvinylidene fluoride and hexafluoropropyrene (PVDF-HFP), polyethylene glycol (PEG), polyacrylonitrile (PAN), polymethyl methacrylate (PMMA), copolymer of those, and the like.

Here, the above-mentioned ion-conducting polymer may be the same as or different from the ion-conducting polymer used as an electrolyte in the active material layer, and is preferably the same. While electrolytic liquid, that is, kinds of a lithium salt and an organic solvent, is not particularly restricted, an electrolyte salt such as lithium salt and an organic solvent such as carbonate are used.

The genuine polymer electrolyte is made by dissolving a lithium salt in the above-mentioned matrix polymer, and does not contain an organic solvent. Accordingly, the use of a genuine polymer electrolyte as the electrolyte eliminates anxiety of liquid leak from a battery to improve the reliability of the battery.

The matrix polymer for the gel polymer electrolyte or the genuine polymer electrolyte can express excellent mechanical strength by forming a cross-linked structure. In order to enable the cross-linked structure to be formed, it is sufficient to subject a polymerizable polymer for forming a polymer electrolyte (for example, PEO or PPO) to a polymerization treatment using an appropriate polymerization initiator. As the polymerization treatment, thermal polymerization, ultraviolet polymerization, radiation polymerization, electron beam polymerization or the like can be used. Meanwhile, the nonaqueous electrolyte contained in the electrolyte layer 13 may be an individual one made of only one kind, or may be a mixed one of two or more kinds.

Moreover, when the electrolyte layer 13 is constituted of a liquid electrolyte or a gel polymer electrolyte, the use of a separator for the electrolyte layer 13 is preferable. An example of the specific form of the separator includes a microporous membrane made of polyolefin such as polyethylene or polypropylene.

### (Shape of battery)

A lithium-ion secondary battery has a structure that a battery element is housed in a battery case such as a can body or a laminating vessel (packaging body). The battery element (electrode structural body) is constituted of a positive electrode and a negative electrode connected via an electrolyte layer. Meanwhile, batteries are classified roughly into a winding type battery in which a battery element has a wound structure of a positive electrode, an electrolyte layer and a negative electrode, and a laminate type battery in which a battery element has a laminated structure of a positive electrode, an electrolyte layer and a negative electrode. The bipolar battery described above has a laminate type structure. Further, in some cases, the lithium-ion secondary battery is referred to so-called a coin cell, a button battery, a laminate battery or the like, according to the shape or structure of a battery case.

### Examples

Hereinafter, the present invention will be described in detail on the basis of Examples. Meanwhile, the present invention is not restricted to these Examples.

### (1) Production of negative electrode

As a sputtering apparatus, a ternary DC magnetron sputtering apparatus of an independent control system (manufactured by Yamatokiki Co., Ltd., combinatorial sputter coating apparatus, distance between gun-sample: about 100 mm) was used. Then, on current collector substrates made of a nickel foil having thickness of 20 µm, each of thin films of negative electrode active material alloys having respective compositions was deposited under following conditions. In this way, 23 negative electrode samples were obtained.

### (Production conditions)

### (1) Targets (manufactured by Koj undo Chemical Lab. Co., Ltd., purity: 4N)

Si: 50.8 mm diameter, 3 mm thickness (with packing plate made of 2 mm thick oxygen-free copper)
Sn: 50.8 mm diameter, 5 mm thickness
Al: 50.8 mm diameter, 5 mm thickness

### (2) Deposition conditions

Base pressure: about 7 × 10⁻⁶Pa
Sputtering gas type: Ar (99.9999% or higher)
Sputtering gas introduction rate: 10 sccm
Sputtering pressure: 30 mTorr
DC power source: Si (185 W), Sn (0 to 40 W), Al (0 to 150 W)
Pre-sputtering time: 1 minute
Sputtering time: 10 minutes
Substrate temperature: room temperature

That is, in the present Example, the above-mentioned Si target, Sn target and Al target were used, sputtering time was fixed for 10 minutes, and the power of DC power source was varied in the above-mentioned range. In this way, an alloy thin film in an amorphous state was deposited on a Ni substrate, and negative electrode samples equipped with each of alloy thin films having various compositions were obtained. Component compositions of these alloy thin films are shown in Table 1 and FIGS. 1 to 4.

Here, a few examples of sample production are shown. In Example 4, DC power source 1 (Si target) was set at 185 W, DC power source 2 (Sn target) was set at 25 W, and DC power source 3 (Al target) was set at 130 W. Further, in Comparative Example 2, the DC power source 1 (Si target) was set at 185 W, the DC power source 2 (Sn target) was set at 30 W, and the DC power source 3 (Al target) was set at 0 W. Furthermore, in Comparative Example 5, the DC power source 1 (Si target) was set at 185 W, the DC power source 2 (Sn target) was set at 0 W, and the DC power source 3 (Al target) was set at 78 W.

Meanwhile, analysis of the obtained alloy thin films was performed by an analysis method and analysis apparatus below.

### (Analysis method)

Composition analysis: SEM/EDX analysis (JEOL Ltd.), EPMA analysis (JEOL Ltd.)
Film thickness measurement (for calculating sputtering rate): film thickness meter (TOKYO INSTRUMENTS, INC.)
Film state analysis: Raman spectroscopy (BRUKER Co., Ltd.)

### (2) Production of battery

Each of negative electrode samples obtained as mentioned above and a counter electrode made of lithium foil were faced to each other via a separator, and, after that, an electrolytic liquid was poured to produce CR 2032 type coin cell prescribed in IEC 60086. Here, as the lithium foil, lithium foil manufactured by Honjo Metal Co., Ltd. was used, and one punched out in diameter of 15 mm and thickness of 200 µm was used. Further, as to a separator, Celgard 2400 manufactured by Celgard, LLC was used. Meanwhile, as the above-mentioned electrolytic liquid, one obtained by dissolving LiPF₆ (lithium hexafluorophosphate) in a mixed nonaqueous solvent of ethylene carbonate (EC) and diethyl carbonate (DEC) mixed at a volume ratio of 1:1 so as to give a concentration of 1 M was used.

### (3) Charge/discharge test of battery

For each of batteries obtained in the way as described above, a charge/discharge test below was performed. That is, using a charge/discharge test machine, charge and discharge were performed in a constant-temperature bath set at temperature of 300K (27°C). Meanwhile, as the charge/discharge test machine, HJ0501SM8A manufactured by HOKUTO DENKO CORP. was used, and, as the constant-temperature bath, PFU-3K manufactured by ESPEC CORP was used. In the charge process, that is, in the Li insertion process into a negative electrode to be an evaluation object, a constant current/constant voltage mode was employed, and the charge was performed from 2 V to 10 mV at 0.1 mA. After that, in the discharge process, that is, in the Li desorption process from the above-mentioned negative electrode, a constant current mode was employed and the discharge was performed from 10 mV to 2 V at 0.1 mA. This charge/discharge cycle was defined as one cycle, and was repeated 100 times. Then, a discharge capacity maintenance rate relative to the first cycle was examined for the 50th cycle and the 100th cycle. The result thereof is shown together in Table 1. Meanwhile, as to the discharge capacity, values calculated per alloy weight are shown. Further, "DISCHARGE CAPACITY MAINTENANCE RATE (%)" in Table 1 shows the percentage of the discharge capacity at the 50th or 100th cycle relative to the discharge capacity at the first cycle. That is, it is calculated based on (discharge capacity at 50th cycle or 100th cycle)/(discharge capacity at first cycle) × 100.

**[Table 1]**

| Classification | Negative Electrode Active Material Component (%) | | | Discharge Capacity At 1st Cycle (mAh/g) | Discharge Capacity Maintenance Ratio (%) | | Note |
|---|---|---|---|---|---|---|---|
| | Si | Sn | Al | | At 50th Cycle | At 100th Cycle | |
| Example 1 | 50 | 19 | 31 | 1753 | 92 | 55 | Si-Sn-Al based |
| Example 2 | 45 | 17 | 38 | 1743 | 93 | 57 | |
| Example 3 | 42 | 16 | 42 | 1720 | 95 | 58 | |
| Example 4 | 41 | 16 | 43 | 1707 | 95 | 61 | |
| Example 5 | 44 | 35 | 21 | 2077 | 95 | 55 | |
| Example 6 | 42 | 33 | 25 | 1957 | 93 | 55 | |
| Example 7 | 38 | 29 | 33 | 1949 | 93 | 55 | |
| Example 8 | 37 | 29 | 34 | 1939 | 93 | 56 | |
| Example 9 | 36 | 28 | 36 | 1994 | 94 | 60 | |
| Example 10 | 37 | 45 | 18 | 2004 | 96 | 56 | |
| Example 11 | 35 | 41 | 24 | 1996 | 95 | 55 | |
| Example 12 | 34 | 41 | 25 | 1985 | 95 | 56 | |
| Example 13 | 33 | 40 | 27 | 1893 | 96 | 56 | |
| Example 14 | 31 | 38 | 31 | 1880 | 96 | 62 | |
| Comparative Example 15 | 100 | 0 | 0 | 3232 | 47 | 22 | Pure Si |
| Comparative Example 16 | 56 | 44 | 0 | 1817 | 91 | 42 | Si-Sn based |
| Comparative Example 17 | 45 | 55 | 0 | 1492 | 91 | 42 | |
| Comparative Example 18 | 38 | 62 | 0 | 1325 | 91 | 42 | |
| Comparative Example 19 | 61 | 0 | 39 | 1747 | 41 | 39 | Si-Al based |
| Comparative Example 20 | 72 | 0 | 28 | 2119 | 45 | 38 | |
| Comparative Example 21 | 78 | 0 | 22 | 2471 | 45 | 27 | |
| Comparative Example 22 | 87 | 0 | 13 | 2805 | 44 | 17 | |
| Comparative Example 23 | 97 | 0 | 3 | 3031 | 47 | 17 | |

From Table 1, it was known that batteries in Examples 1 to 14 were excellent in the balance of the first cycle discharge capacity, the 50th cycle discharge capacity maintenance rate and the 100th cycle discharge capacity maintenance rate. That is, it became clear that, when Si was in a range from 12% by mass or more to less than 100% by mass, Sn was in a range from more than 16% by mass to 45% by mass
or less and Al was in a range from more than 18% by mass to
43% by mass or less, the balance was excellent. In contrast, it was known that although batteries in Comparative Examples 1 to 9 might show a large first cycle discharge capacity, lowering in the discharge capacity maintenance rate was remarkable, as compared with batteries in Examples.

To summarize the above results, in the batteries in Examples that use the Si-Sn-Al-based alloy having respective components in the specific range of the present invention as the negative electrode active material, the following was confirmed. That is, it was confirmed that such batteries had a high initial capacity exceeding 1700 mAh/g, showed a discharge capacity maintenance rate of 92% or more at the 50th cycle and of 55% or more even at the 100th cycle, and were excellent in the balance of the capacity and the cycle durability. In contrast, in batteries in Comparative Examples that used alloys having respective components out of the specific range of the present invention, in either of the initial capacity and cycle durability, results that fell below the above numerical values in Examples were obtained. In particular, it became clear that, in the case of an alloy close to pure Si, the cycle characteristics tended to be poor although the capacity was high. Further, it became clear that, in the case of an alloy having a high Sn content, the initial capacity tended to be poor although the cycle characteristics were comparatively excellent.

The entire contents of Japanese Patent Application No. 2011-116707 (filed on May 25, 2011) is herein incorporated by reference.

Although the present invention has been described above by reference to Examples, the present invention is not restricted to these descriptions thereof, and it will be apparent to those skilled in the art that various modifications and improvements can be made.

That is, in the above-mentioned embodiments and Examples, a lithium-ion secondary battery was exemplified as an electric device, but the present invention is not restricted to this, and can be applied to secondary batteries of other types and, furthermore, to primary batteries. Further, it can be applied not only to batteries but also to capacitors. That is, it is sufficient that the negative electrode for an electric device and the electric device of the present invention contain inevitably the prescribed alloy as the negative electrode active material, and other constituents shall not be restricted particularly.

Further, the present invention can be applied not only to the above-mentioned laminate type battery, but also to button type batteries and can type batteries. Furthermore, the present invention can be applied not only to the above-mentioned laminate type (flat type) batteries, but also to wound type (cylinder type) batteries. Further, the present invention can also be applied, from the view of an electric connection state in lithium-ion secondary batteries, not only to batteries of the above-described internal parallel connection type, but also to batteries of internal series connection type such as a bipolar battery. Meanwhile, a battery element in a bipolar battery generally has such a constitution that a plurality of bipolar electrodes in each of which a negative electrode active material layer is formed on one surface of a current collector and a positive electrode active material layer is formed on the other surface thereof, and a plurality of electrolyte layers are laminated.

### INDUSTRIAL APPLICABILITY

According to the present invention, as a negative electrode active material for an electric device, a silicon alloy containing Si, Sn and Al in the above-described composition range is used. The use of such negative electrode active material for an electric device such as a lithium-ion secondary battery improves the cycle life of the device and allows the device to be excellent in the capacity and cycle durability.

### REFERENCE SIGNS LIST

- 1: lithium-ion secondary battery
- 10: battery element
- 11: positive electrode
- 11A: positive electrode current collector
- 11B: positive electrode active material layer
- 12: negative electrode
- 12A: negative electrode current collector
- 12B: negative electrode active material layer
- 13: electrolyte layer
- 14: single cell layer
- 21: positive electrode tab
- 22: negative electrode tab
- 30: sheathing body

## Claims

1. A negative electrode active material for a lithium ion secondary battery (1), comprising an alloy containing Si in a range from 12% by mass or more to less than 100% by mass, Sn in a range from 16% by mass or more to 45% by mass or less, Al in a range from 18% by mass or more to 43% by mass or less, and indispensable impurities as remains.

2. The negative electrode active material for a lithium ion secondary battery (1) according to claim 1, wherein a Si content of the alloy is 31% by mass or more.

3. The negative electrode active material for a lithium ion secondary battery (1) according to claim 2, wherein the Si content of the alloy is 50% by mass or less.

4. A negative electrode (12) for a lithium ion secondary battery (1), comprising the negative electrode active material for a lithium ion secondary battery (1) according to any one of claims 1 to 3.

5. A lithium ion secondary battery (1) comprising the negative electrode active material for a lithium ion secondary battery (1) according to any one of claims 1 to 3.

6. A lithium ion secondary battery (1) comprising the negative electrode (12) for a lithium ion secondary battery (1) according to claim 4.

## Patentansprüche

1. Negativelektrodenaktivmaterial für eine Lithiumionen-Sekundärbatterie (1), umfassend eine Legierung, die Si in einem Bereich von 12 Masse% oder mehr bis weniger als 100 Masse%, Sn in einem Bereich von 16 Masse% oder mehr bis 45 Masse% oder weniger, Al in einem Bereich von 18 Masse% oder mehr bis 43 Masse% oder weniger und unvermeidbare Verunreinigungen als Rest enthält.

2. Negativelektrodenaktivmaterial für eine Lithiumionen-Sekundärbatterie (1) nach Anspruch 1, wobei ein Si-Gehalt der Legierung 31 Masse% oder mehr beträgt.

3. Negativelektrodenaktivmaterial für eine Lithiumionen-Sekundärbatterie (1) nach Anspruch 2, wobei der Si-Gehalt der Legierung 50 Masse% oder weniger beträgt.

4. Negativelektrode (12) für eine Lithiumionen-Sekundärbatterie (1), die das Negativelektrodenaktivmaterial für eine Lithiumionen-Sekundärbatterie (1) nach einem der Ansprüche 1 bis 3 umfasst.

5. Lithiumionen-Sekundärbatterie (1), die das Negativelektrodenaktivmaterial für eine Lithiumionen-Sekundärbatterie (1) nach einem der Ansprüche 1 bis 3 umfasst.

6. Lithiumionen-Sekundärbatterie (1), welche die Negativelektrode (12) für eine Lithiumionen-Sekundärbatterie (1) nach Anspruch 4 umfasst.

## Revendications

1. Matériau actif d'électrode négative pour une batterie secondaire au lithium-ion (1), comprenant un alliage contenant du Si dans une plage allant de 12% en masse ou plus à moins de 100% en masse, du Sn dans une plage allant de 16% en masse ou plus à 45% en masse ou moins, de l'Al dans une plage allant de 18% en masse ou plus à 43% en masse ou moins, et des impuretés inévitables en tant que reste.

2. Matériau actif d'électrode négative pour une batterie secondaire au lithium-ion (1) selon la revendication 1, dans lequel une teneur en Si de l'alliage est supérieure ou égale à 31% en masse.

3. Matériau actif d'électrode négative pour une batterie secondaire au lithium-ion (1) selon la revendication 2, dans lequel la teneur en Si de l'alliage est inférieure ou égale à 50% en masse.

4. Électrode négative (12) pour une batterie secondaire au lithium-ion (1), comprenant le matériau actif d'électrode négative pour une batterie secondaire au lithium-ion (1) selon l'une quelconque des revendications 1 à 3.

5. Batterie secondaire au lithium-ion (1) comprenant le matériau actif d'électrode négative pour une batterie secondaire au lithium-ion (1) selon l'une quelconque des revendications 1 à 3.

6. Batterie secondaire au lithium-ion (1) comprenant l'électrode négative (12) pour une batterie secondaire au lithium-ion (1) selon la revendication 4.
